# EUROPEAN PATENT SPECIFICATION

(11) **EP 1 052 520 B1**
(45) Date of publication and mention of the grant of the patent: **27.07.2005**
(21) Application number: 99303615.1
(22) Date of filing: 10.05.1999
(51) Int. Cl.: G01R 33/09, H01F 10/08, G11B 5/33

(54) **Magnetoelectric device**
Magnetoelektrischer Vorrichtung
Dispositif magnétoélectrique

(43) Date of publication of application: 15.11.2000
(73) Proprietor: HITACHI EUROPE LIMITED, Maidenhead, Berkshire, SL6 8YA (GB)
(72) Inventor: Tsukagoshi, Kazuhito, Cambridge CB4 1YE (GB); Alphenaar, Bruce W., Cambridge CB3 OHW (GB); Mizuta, Hiroshi, Cambridge CB4 6ZR (GB)
(74) Representative: Read, Matthew Charles

(56) References cited:
- WO-A-98/25263
- US-A- 5 726 837
- US-A- 5 747 859
- TSEBRO V I ET AL: "TEMPERATURE DEPENDENCE OF ELECTRIC RESISTANCE AND MAGNETORESISTANCEOF PRESSED NANOCOMPOSITES OF MULTILAYER NANOTUBES WITH THE STRUCTURE OF NESTED CONES" JOURNAL OF EXPERIMENTAL AND THEORETICAL PHYSICS, vol. 86, no. 6, 1 June 1998 (1998-06-01), pages 1216-1219, XP000776015 ISSN: 1063-7761

## Description

This invention relates to a magnetoelectric device responsive to an applied magnetic field, which has particular but not exclusive application to a magnetic reading head for reading data from magnetic storage media.

Large magnetoresistance can be observed in certain structures that include regions of ferromagnetic material which are separated by regions of non-magnetic material. In these structures, the resistance drops dramatically as a magnetic field is applied, the change being much greater than for a single ferromagnetic film. The effect is believed to due to relative alignment of the magnetisation directions of different layers of the structure. For example, considering a structure that comprises first and second ferromagnetic layers, when the magnetisation direction of the two ferromagnetic layers are aligned in anti-parallel, electrons with a particular spin can pass through one of the layers but are blocked by the other layer and cannot pass through it. However, in response to an applied magnetic field, the magnetisation direction of one of the layers can be made to flip into parallel with the other layer. Then, electrons with a spin orientation that can pass through the first ferromagnetic layer, will also freely pass through the second ferromagnetic layer, resulting in a relatively low resistance. The effect can therefore be used to detect the presence of an applied magnetic field.

A giant magnetic tunnelling effect has been observed in cobalt containing ferromagnetic layers spaced apart by an insulating tunnelling barrier of aluminium oxide, as described by T. Miyazaka and N. Tezuka "Giant Magnetic Tunnelling Effect in Fe/Al₂O₃/Fe junction", J. Magn. Magn. Mater. 139, L231-L234. It has been proposed to use a magnetoelectric device of this general configuration in a magnetic reading head, as described in "TMR as a promising device for third generation hard disk drive heads" Nikkei Electronics 1997, 47 No. 686 pp 125-129. The magnetoelectric device used in the reading head comprises first and second overlying ferromagnetic layers formed of cobalt with a thickness of 3.3nm, sandwiching a tunnelling insulating Al₂O₃ layer of thickness 1.3nm, to act as a thin tunnelling barrier to channel electrons between the ferromagnetic layers. The various layers are deposited sequentially on an insulating substrate. The tunnel barrier of Al₂O₃ is formed by oxidising a thin aluminium layer deposited on one of the cobalt layers. The oxidisation process takes 10 hours or longer which slows the manufacturing process. Furthermore, the aluminium oxide film needs to have a high quality and uniformity in order to render the device sensitive to an applied magnetic field. Short circuits due to pin holes through the tunnelling barrier constitute a serious problem. Furthermore, the magnetoelectric device needs to be made sufficiently small to detect individual storage areas on magnetic media with the result that the resistance through the device is relatively high and sensitive to external noise.

US 5 747 859 A discloses a magnetic sensor having a three-terminal magnetic device consisting of an emitter, a base and a collector. A semiconductor layer serves as the collector and a magnetic multilayered film has two magnetic films opposing each other with a non-magnetic film between them. The emitter which is constructed of a metal film and the base are connected via a tunnel insulating film. The relationship between the magnetization directions in the magnetic films changes in accordance with an external magnetic field, and this changes the value of a current flowing through the magnetic device. The external magnetic field is sensed on the basis of this change in the current value.

WO 98/25263 discloses another magneto-electric device wherein the two ferromagnetic regions are laterally spaced on a substrate with a semiconductor layer between them containing a quasi two-dimensional electron gas (2DEG). The 2DEG has relatively large electronic mean free path and high electron mobility allowing a greater distance between the ferromagnetic regions.

The present invention seeks to provide an improved device.

According to the invention there is provided a magnetoelectric device responsive to an applied magnetic field, comprising first and second ferromagnetic regions with a channel region between them, the ferromagnetic regions being configured so that charge carriers with a particular spin polarisation which can pass through the first region, pass through the second region as a function of the relative orientations of magnetisation of the ferromagnetic regions produced by the applied magnetic field whereby the device exhibits a conductivity as a function of the strength of the applied field, wherein that the channel region is configured to provide a quasi-one-dimensional channel to cause charge carriers which pass through the first ferromagnetic region to maintain their spin polarisation as they pass towards the second ferromagnetic region.

The quasi-one-dimensional channel may comprise a nanotube, which may be formed of carbon. The channel region may comprise a bundle of such nanotubes.

The channel region in another aspect of the invention may comprise a layer of graphite or a diamond layer.

In order that the invention may be more fully understood an embodiment thereof will now be described by way of example with reference to the accompanying drawings in which:
Figure 1 is a schematic cross sectional view of the first example of magnetoelectric device according to the invention;
Figure 2 is a schematic plan view of the device shown in Figure 1;
Figure 3 is an electron beam micrograph of the channel region of the device shown in Figures 1 and 2;
Figure 4 is a graph of the resistance of the device as a function of applied magnetic field;
Figure 5 is a table illustrating the relationship between resistance, spin orientation and field strength;
Figure 6a-h illustrate process steps of a first fabrication method of making a device according to the invention showing the various steps in plan and sectional view respectively;
Figure 7a-n correspondingly illustrate a second fabrication method for a device according to the invention;
Figure 8 is a schematic plan view of a further embodiment of magnetoelectric device according to the invention in which the carbon nanotube is configured as a bridge;
Figure 9 is a schematic plan view of another device according to the invention in which the carbon nanotube is arranged at side edges of the ferromagnetic regions;
Figure 10 is a schematic plan view of a magnetoelectric device using a plurality of carbon nanotubes;
Figure 11 is a schematic view of a device in which the plurality of nanotube are arranged in a bridge configuration;
Figure 12 illustrates in perspective view another device according to the invention using a bundle of nanotubes upstanding from the substrate;
Figure 13 illustrates in plan view another device according to the invention using a bundle of nanotubes disposed transversely on the substrate;
Figure 14 illustrates another device in plan view in which the bundle of nanotubes is arranged as a bridge between the ferromagnetic regions;
Figure 15 is a schematic plan view of a device using a carbon graphite or diamond tunnelling region;
Figure 16 corresponds to Figure 15 in which the carbon region is arranged as a bridge between the ferromagnetic regions;
Figure 17 is another example of a device according to the invention using a carbon graphite film on the substrate;
Figure 18 illustrates a device with a doped substrate to receive a gate voltage;
Figure 19 is a plan view of a device according to the invention with a side gate;
Figures 20a-h illustrate process steps for making another example of spin device according to the invention;
Figure 21 illustrates a first example of a magnetic reading head incorporating a magnetoelectric device according to the invention; and
Figure 22 illustrates another example of magnetic reading head incorporating the inventive magnetoelectric device.

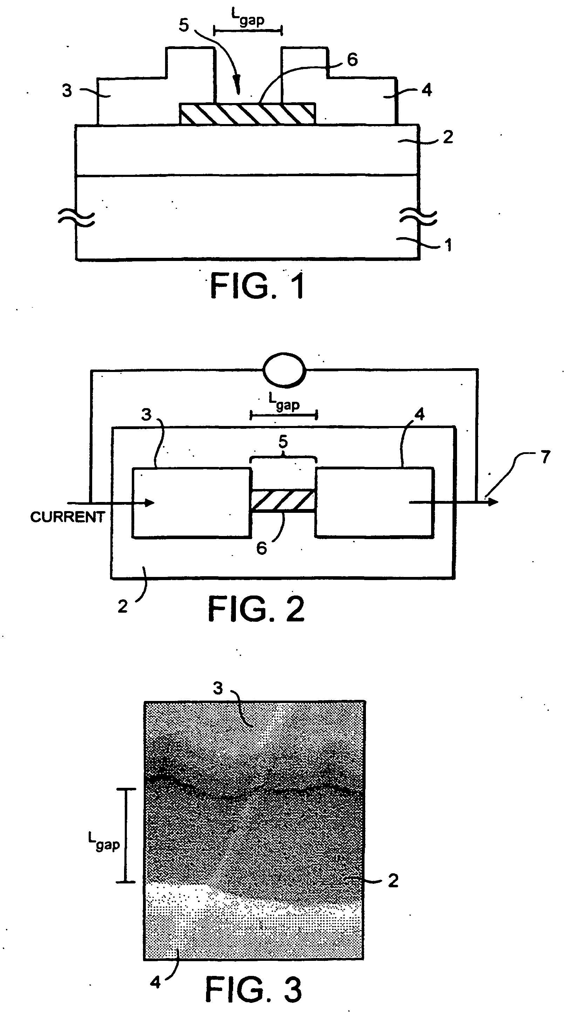

A first embodiment of a magnetoelectric device according to the invention is shown in Figures 1 to 3. Referring to the sectional view of Figure 1, the device comprises generally planar support 1 which may comprise a semiconductor wafer or could comprise a metal plate. An insulating substrate 2 is formed on the wafer 1 e.g. of SiO₂ or SiN. First and second ferromagnetic regions 3, 4 are formed on the substrate 2, with a channel region 5 between them. In this embodiment, the channel region 5 has a width L_{gap} between the first and second ferromagnetic regions 3, 4 which may be of the order of 250nm. The ferromagnetic regions 3,4 may be made of cobalt deposited to a thickness of 50-100 nm. Typical dimensions for the region 3 are 2 by 2 micrometers although the invention is not restricted to these dimensions. As will be explained in more detail later, the regions 3,4 have slightly different surface areas to give them asymmetrical magnetisation characteristics.

In this example of the invention, a carbon nanotube 6 extends through the channel region 5 between the ferromagnetic regions 3, 4 in order to channel electrons between them. The direction of current flow is shown by arrows 7 in Figure 2. As known in the art, carbon nanotubes comprise hollow, generally cylindrical members with a diameter typically in the range of 1.4 - 20nm and a length of the order of 65 micrometers. Either single or multi-walled nanotubes can be used. Carbon nanotubes are commercially available from Shinku Yakin K.K. of Japan. Nanotubes are described in more detail in "Physical Properties of Carbon Nanotubes," R. Saito, G. Dresselhaus and M.S. Dresselhaus, Imperial College Press, London, 1998.

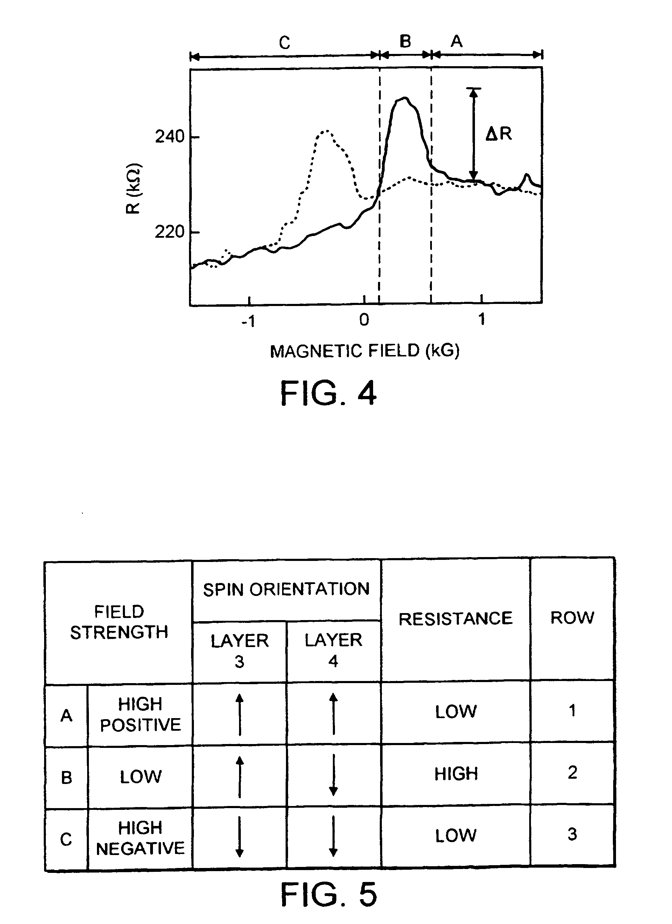

Figure 4 illustrates the resistive characteristics of the device in the presence of a magnetic field. When a relatively high magnetic field is applied to the magnetoelectric device (region A) the high field causes the magnetisation directions for the ferromagnetic regions 3, 4 to become aligned with the field. A characteristic of ferromagnetic material is that the majority of the conduction electrons have a spin-orientation corresponding to the magnetisation direction of the ferromagnetic material. For instance, in the high positive field condition A, the majority of electrons in layer 4 will have a spin orientation corresponding to the upright arrow shown in Figure 5 (row 1). The electrons pass from the layer 4 through the carbon nanotube 6 to the ferromagnetic layer 3 with little spin scattering, due to carbon nanotube having a large spin-scattering length. The high field, as previously explained, aligns the magnetisation directions for the layers 3 and 4 in parallel. Since the majority spin states are also aligned, the device exhibits a relatively low resistance.

When the field is reduced to a low value (region B of Figure 4) one of the layers 3, 4 flips its magnetisation direction into an anti-parallel configuration as shown in row 2 of Figure 5. In this situation, the majority spin states are out of alignment. As a result, the device exhibits high resistance.

The flipping of one of the layers into the antiparallel magnetisation configuration in the low strength field, results from the layers 3, 4 exhibiting slightly different bulk coersivities due to their different surface areas, so that one of the layers flips its orientation direction before the other in response to the decreasing field.

If the field direction is reversed and a high negative field is applied, the magnetisation of the second layer eventually also flips in the direction of the applied field. In this situation, the majority spin states of both layers are once again aligned, so the device exhibits a relatively low electrical resistance, as shown in row 3 of Figure 5.

The ferromagnetic layers 3, 4 exhibits hysteresis so that when the magnetic field is reversed, the characteristic shown in dotted outline in Figure 4 is produced.

It has been found in accordance with the invention, that the use of the carbon nanotube 6 gives rise to an improved differential resistance ΔR between the high and low field states, as compared with prior art devices using an Al₂O₃ tunnel barrier layer. The reason for the improvement is not fully understood but a characteristic of the carbon nanotube is that it provides a quasi-one-dimensional channel extending between the ferromagnetic regions 3, 4 and it is postulated that this permits the spin polarised electrons emerging from ferromagnetic layer 4 to retain their spin polarisation as they are carried into the second ferromagnetic layer 3, with minimal scattering, thereby increasing the value of ΔR.

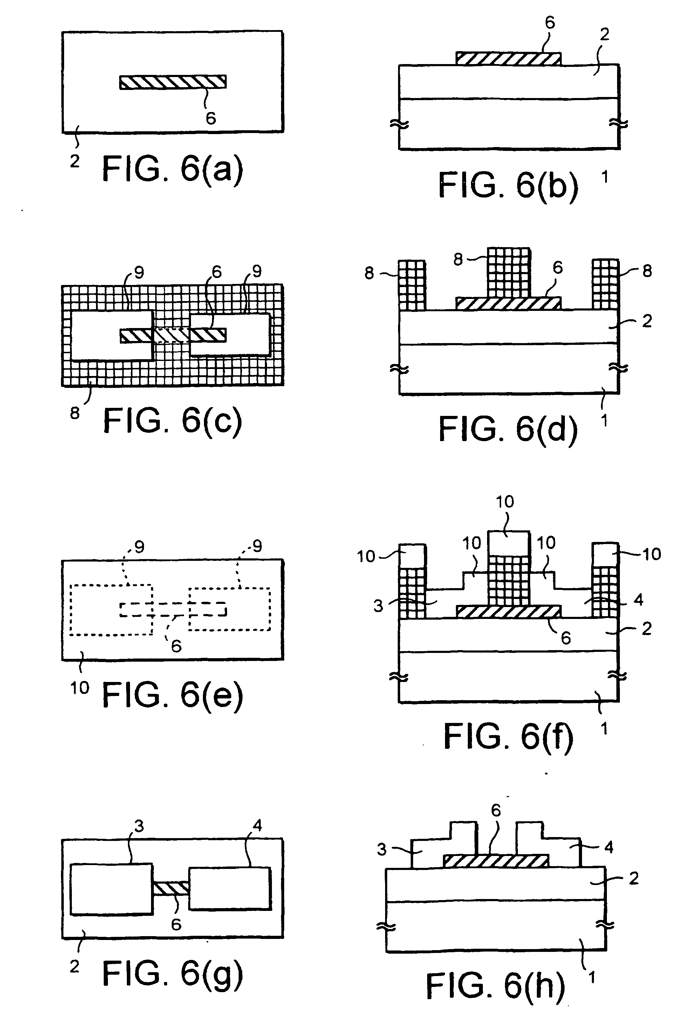

A method of manufacturing the device shown in Figures 1 to 3 will now be described with reference to Figure 6. As shown in Figure 6a, and the corresponding sectional view 6b, the semiconductor substrate 1 is formed with an oxide layer 2 to a thickness of 200 nm. Then, carbon nanotube 6 is placed on the surface. This is carried out by forming a suspension of nanotubes in dichloroethane and using ultrasound to homogenise the suspension. The resulting liquid suspension is then spread over the oxide layer 2 and dried so as to deposit the nanotubes. One of the nanotubes is then located on the surface using a microscope (not shown).

As shown in Figure 6e and the corresponding sectional view 6d, a layer of electron beam resist material 8 is applied. A suitable example is NANO PMMA resist produced by Microlithography Corporation. The resist layer 8 is subject to an electron-beam lithographic process which defines areas 9 for the eventual ferromagnetic regions 3, 4, at opposite ends of the nanotube 6. Alternatively, a high resolution optical lithographic technique can be used with a suitable resist in order to form the areas 9.

Then, referring to Figures 6e, f, a layer 10 of cobalt ferromagnetic material is deposited by thermal evaporation to a thickness of 50-100 nm at a pressure of 4x10⁻⁷torr, at room temperature. E-beam evaporation could alternatively be used. Then, as shown in Figures 6g, h, the resist 8 is removed by dissolving it with acetone so as to leave the first and second ferromagnetic regions 3, 4 on the substrate, electrically connected to opposite ends of the nanotube 6. It will be noted that the ferromagnetic region 3 is larger than the corresponding region 4 in surface area to ensure asymmetrical flipping of the associated electron spin states, as previously described.

Additional metallic contact layers of Au (not shown) are provided on the ferromagnetic regions 3, 4 to allow an external voltage source to be connected so that the resistance of the device can be measured to detect an applied magnetic field.

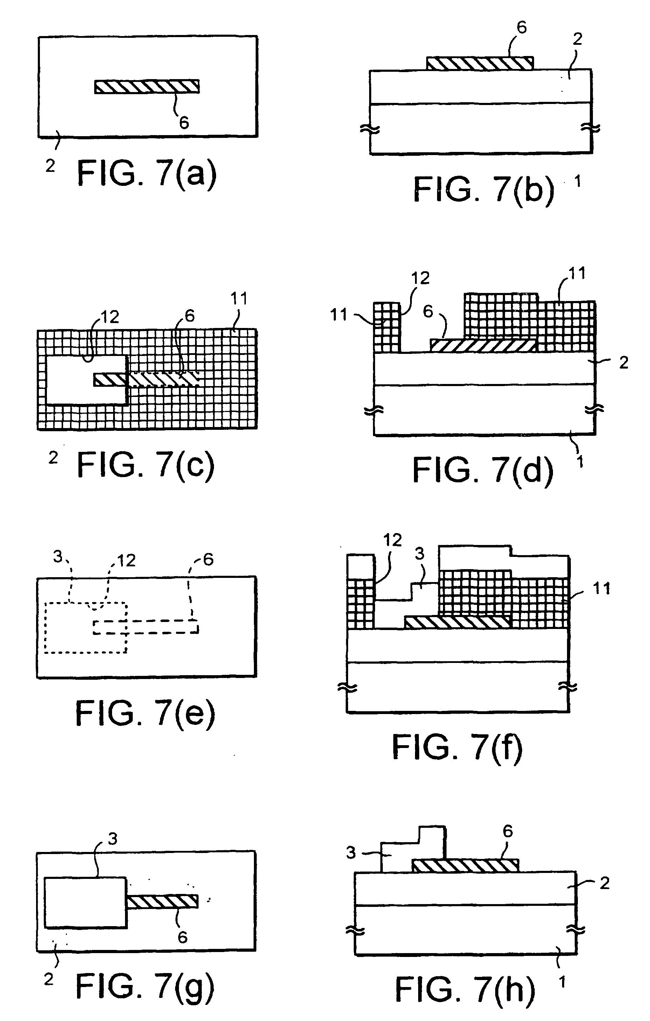

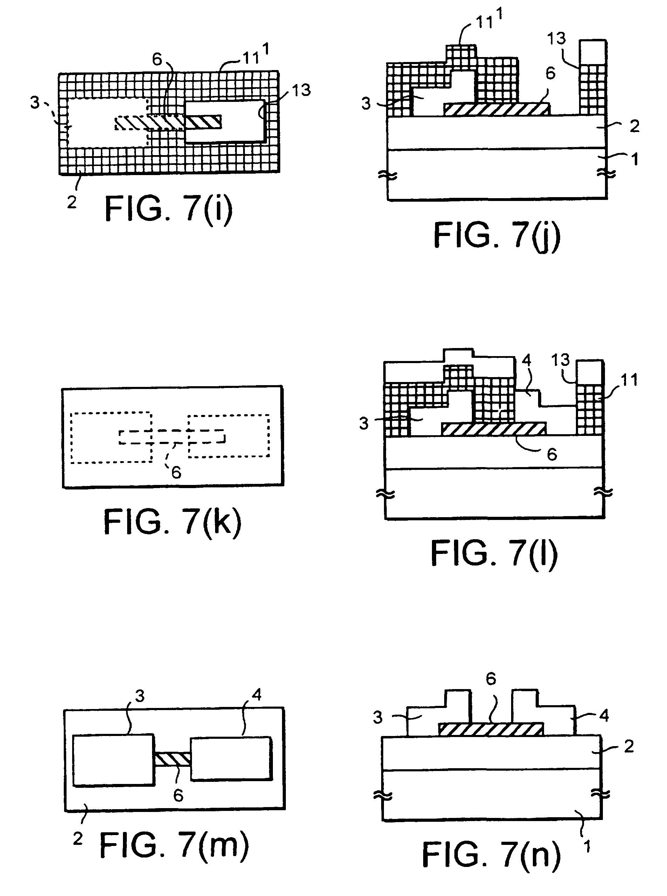

This manufacturing process deposits the same ferromagnetic material for both of the ferromagnetic regions 3, 4. However, an alternative process may be used to allow different ferromagnetic materials to be used for the individual regions. In this way, different ferromagnetic regions with different coersivities can be provided to provide asymmetrical flipping of their spin states in response to the applied field. The process will now be described with reference to Figure 7. As shown in Figures 7a and b, the substrate 1, oxide layer 2 and nanotube 6 are prepared as previously described. Then, as shown in Figures 7c, d, a photoresist layer 11 is applied and a window 12 is opened in it as previously described for the layer 8, to define the ferromagnetic region 3 overlying one end of the nanotube 6.

Then, as shown in Figures 7e, f, a first ferromagnetic film is deposited to a thickness of 30-35 nm so as to form the ferromagnetic region 3 in the opening 12 of a first ferromagnetic material. Suitable examples are Co, Ni and Fe. Suitable deposition conditions are room temperature and a pressure of 4x10⁻⁷ torr.

Then, the photoresist material and the overlying ferromagnetic material is removed by a conventional lift-off method in which the resist is dissolved in acetone so as to provide the configuration shown in Figures 7g, h, with the ferromagnetic region 3 contacting one end of the carbon nanotube 6.

A similar process is then repeated at the other end of the nanotube 6. Referring to Figure 7i, j, another layer 11' of the previously described resist is applied over the surface of the substrate, covering the first ferromagnetic region 3, and a window 13 is provided in it by the conventional lithographic techniques previously described, to form an opening for the second ferromagnetic region 4, at the other end of the carbon nanotube 6. A second ferromagnetic material is then applied, in the same way as the first region 3, so as to form the second ferromagnetic region 4 to a thickness of 30-35 nm under the same conditions of temperature and pressure as for region 3. The material for the second region is in this example different from the material used for region 3. Examples are Co, Ni and Fe. The resist material is then removed so to provide the configuration shown in Figures 7m, n. It will be seen that the regions 3, 4 can be of the same size but because they are of different ferromagnetic materials, the spin states of the individual regions will flip at different field strengths so as to provide the characteristics shown in Figure 4 and 5 in response to an applied magnetic field. As previously explained, additional contact regions may be provided on the individual ferromagnetic regions 3, 4 to provide external connections.

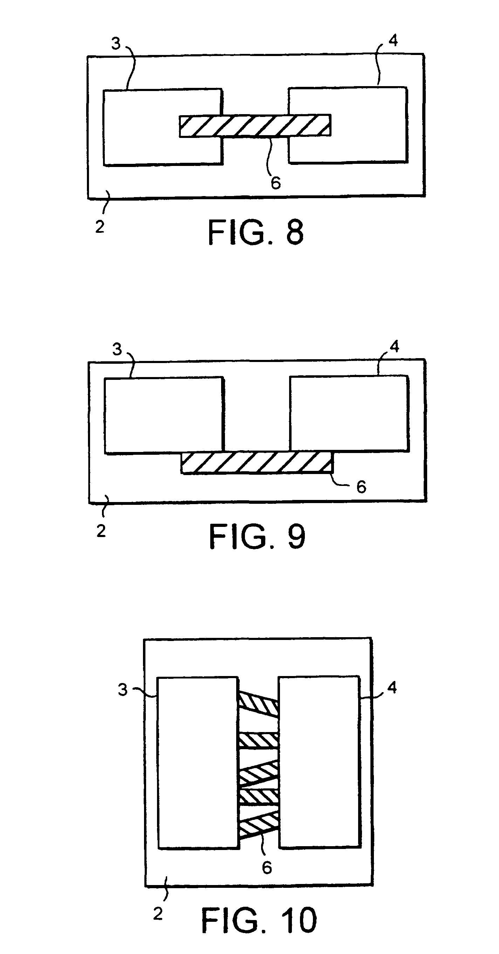

Various other modifications and variations fall within the scope of the invention as defined in the appended claims. For example, referring to Figure 8, the fabrication process can be modified to deposit the first and second ferromagnetic regions 3, 4 firstly and thereafter to position the carbon nanotube overlying the ferromagnetic regions as a bridge. The nanotube 6 may be positioned using an atomic force microscope or by modifying the surface of the oxide layer 2 chemically, either to attract or repel nanotubes.
Also, as shown in Figure 9, the nanotube 6 may be positioned in contact with side edges of the regions 3, 4 rather than bridging them as shown in Figure 8.

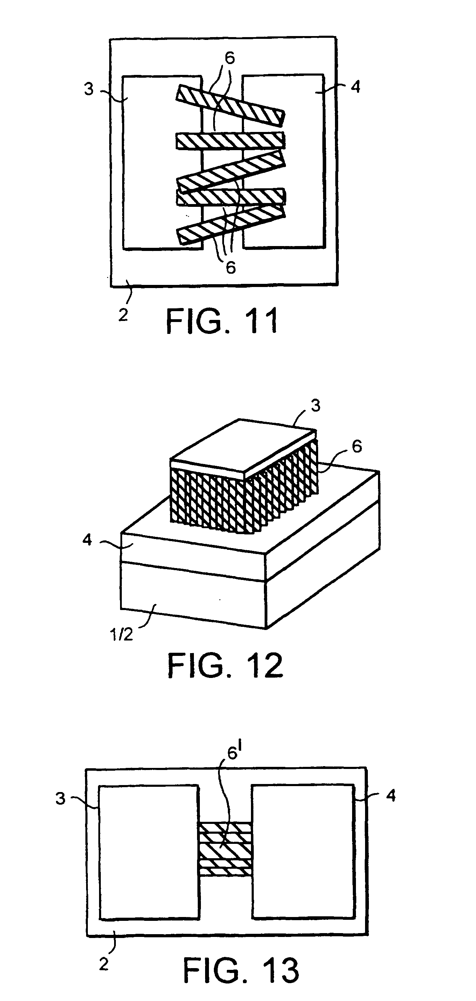

Furthermore, in order to reduce the electrical resistance, a plurality of nanotubes 6 may be used as shown in Figure 10 and 11. In Figure 10, the nanotubes 6 are arranged in contact with ferromagnetic regions 3, 4 formed by either of the processes previously described with reference to Figures 6 and 7. Alternatively, the nanotubes may bridge the ferromagnetic regions 3, 4 as shown in Figure 11. In another modification shown in Figure 12, the nanotubes 6 are arranged upstanding from the substrate 2 with the ferromagnetic regions 3, 4 above and below their ends.

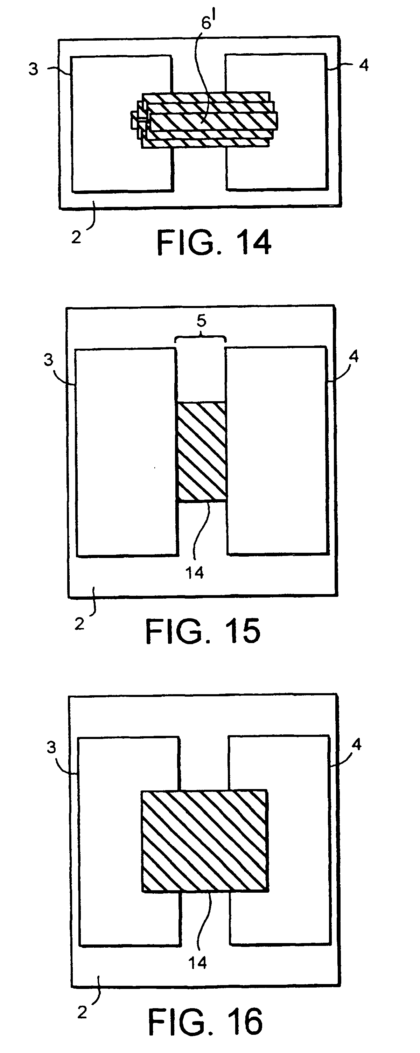

As known in the art, carbon nanotubes can aggregate to form a bundle and this can be utilised in devices according to the invention to reduce the electrical resistance. For example, as shown in Figure 13, a bundle of nanotubes 6' is used instead of a single tube on the substrate 2. Also, as shown in Figure 14, the nanotube bundle 6' can bridge the contacts 3, 4 rather than being configured beneath them as shown in Figure 13. A typical nanotube bundle 6' contains between two and several hundred nanotubes although the invention is not restricted to this range.

Those skilled in the art will appreciate that nanotubes can be made from other materials such as silicon or boron nitride, which may be used as alternatives to the carbon tube 6, 6'.

Further examples of the invention will now be described that use a channel region with a carbon containing material which, instead of being configured as a nanotube is arranged in a carbon layer. Referring to Figure 15, a region 14 comprising carbon graphite is formed on the substrate 2 by chemical vapour deposition (CVD) to a thickness of 100 nm and is patterned to dimensions of 100 by 100 micrometers using a photolithographic or e-beam lithographic technique when the substrate is initially prepared, instead of using the nanotube 6. The ferromagnetic regions 3, 4 are then applied as previously described with reference to either Figure 6 or 7. In a modification, the graphite region 14 may be replaced by diamond.

In an alternative shown in Figure 16, the region 14 is arranged as a bridge between the ferromagnetic regions 3, 4 using conventional lithographic techniques and thermal evaporation.

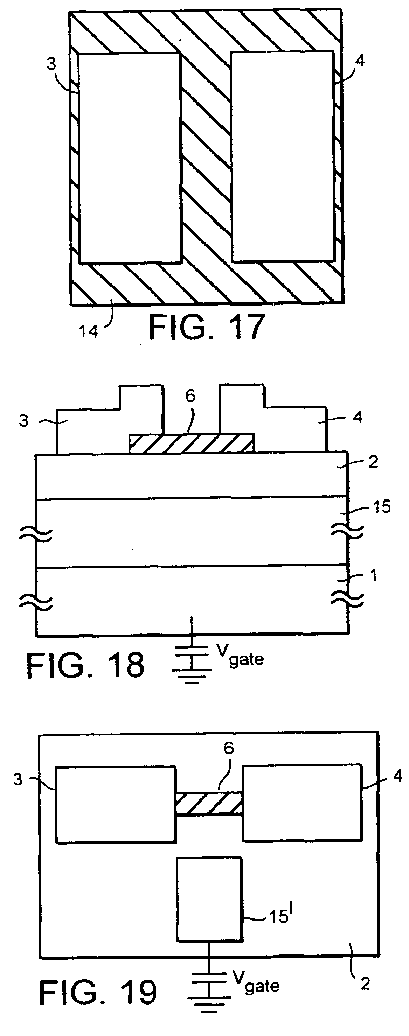

In an alternative shown in Figure 17, a region of the substrate 2 that is larger than the ferromagnetic regions 3, 4 is initially deposited with the graphite or diamond layer and the ferromagnetic regions 3, 4 are formed thereon. An example of the dimensions for the region 14 is 100 by 100 micrometers and for the regions 3, 4 is 2 by 2 micrometers The resulting magnetoelectric device that uses the carbon graphite/diamond layer exhibits an improved resistance characteristic as compared with the Al₂O₃ insulating layers used in the prior art.

The magnetoelectric device according to the invention may be provided with a gate to control its conduction characteristics. As shown in Figure 18, an example of the device using a carbon nanotube 6 is provided with a doped region 15 in the substrate 1 to allow a gate voltage V_{gate} to be applied to influence charge tunnelling through the channel region 5. In an alternative shown in Figure 19, a side gate 15 is provided on the surface of the substrate, by conventional photolithographic techniques, to apply a field to control conduction through the tunnel channel region 5, along the nanotube 6.

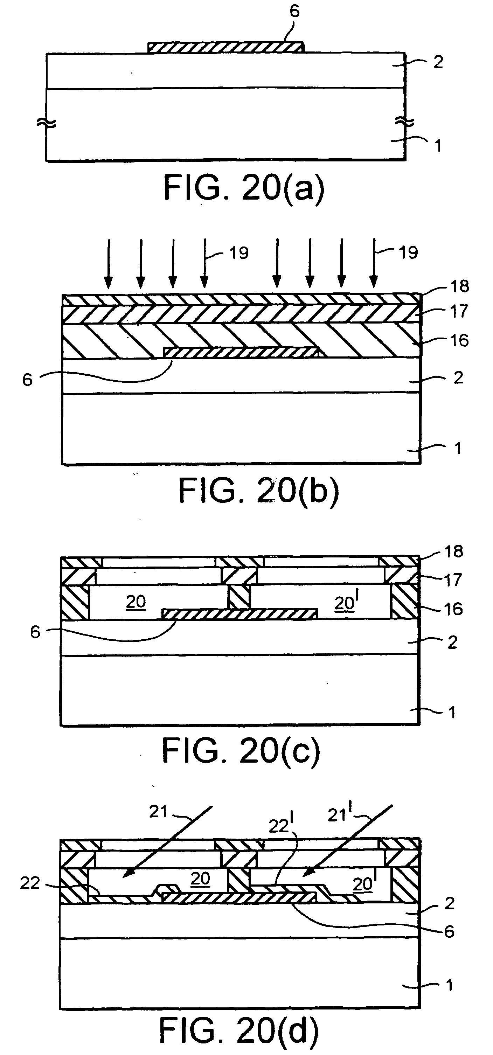

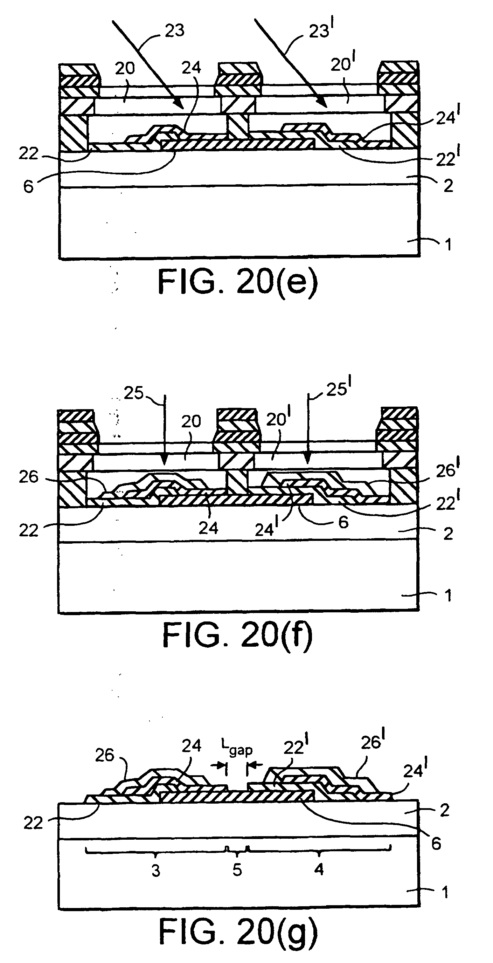

Another fabrication process for a device according to the invention will now be described with reference to Figure 20. A silicon substrate 1 is prepared with an overlying 200nm SiO₂ layer, with a nanotube 6 thereon, as previously described with reference to Figure 1. This is shown in Figure 20a.

Then, as shown in Figure 20b, a series of resist layers 16, 17, 18 are spun successively onto the substrate. The lowermost layer 16 comprises MMA or MAA and is deposited to a thickness of 300 nm. The layer 16 is overlaid by the first PMMA layer 17 of a material with a higher molecular weight than the layer 16, to a thickness of 50 nm. This is overlaid by a second layer of PMMA resist 18 of a higher molecular weight than the layer 17, to a thickness of 50 nm.

The resist layers are then exposed to an electron beam 19 which exposes regions corresponding to the eventual first and second ferromagnetic regions 3, 4, in a manner known *per se.*

The resist layers are then developed as shown in Figure 20c using a conventional developer such as IPA or MIBK, so as to open windows 20, 20' in the resist layers corresponding to the eventual ferromagnetic regions 3, 4, at opposite ends of the nanotube 6. The rate of dissolution of layer 16 is greater than that of layer 17, which in turn is greater than layer 18 as a result of their relative molecular weights. This gives rise to the stepped configuration of the layers 16, 17, 18 as shown in Figure 20c.

Then, the ferromagnetic materials are deposited by evaporation into the windows 20, 20'. Referring to Figure 20d, the substrate 1 is mounted in an evacuation chamber on a pivotally mounted holder so that it can be turned at different angles relative to an induction boat (not shown) which produces a stream of evaporated material, directed towards the substrate.

Referring to Figure 20d, the substrate 1 is pivoted so that the evaporated material is directed at an acute angle shown by arrows 21, 21' into the windows 20, 20'. As a result, a first ferromagnetic material, which may be Fe, Co or Ni, is deposited on the left hand side of each window 20, 20' as layers 22, 22', in electrical contact with opposite ends of the nanotube 6. The evaporation process is carried out at room temperature and at a pressure of 4x10⁻⁷ torr. The layer 22, 22' is deposited to a thickness of 30 nm.

Then, as shown in Figure 20e, the substrate 1 is pivoted in its holder relative to the induction boat so that a second evaporation can take place at an obtuse angle relative to the boat, so as to deposit material at the right hand side of each window 20, 20' as illustrated by arrows 23. 23'. A further ferromagnetic material is thereby deposited as layer regions 24, 24' at the right hand side of each window 20, 20'. The second ferromagnetic material 24, 24' may be of the same or different composition as compared with the material of layer 22, 22'. It will be seen that the layer 24 contacts the nanotube for the most part in the window 20, whereas the layer 24' contacts the nanotube for the most part in the opposite window 20'. Thus, ferromagnetic materials with different coersivity characteristics can be provided in the windows 20, 20' individually.

The deposition conditions for layer 24 are substantially the same as those previously described for layer 22, which is deposited to a thickness of 30 nm.

Then, as shown in Figure 20f, the substrate is pivoted to a central position directly below the induction boat so that a further evaporation process can be carried out in the direction of arrows 25, 25'. In this way, an overlying contact layer 26, 26' is deposited in the windows 20, 20' typically to a thickness of 60 nm. This capping layer, which may be formed of Au, protects the surface of the ferromagnetic material.

Then, as shown in Figure 20g, the remaining resist layers are lifted off using acetone developer as previously described with reference to Figures 6 and 7, so as to leave the deposited layers 22, 24 and 26 at opposite ends of the nanotube 6, thereby to provide the first and second ferromagnetic regions 3, 4 with the gap 5 between them.

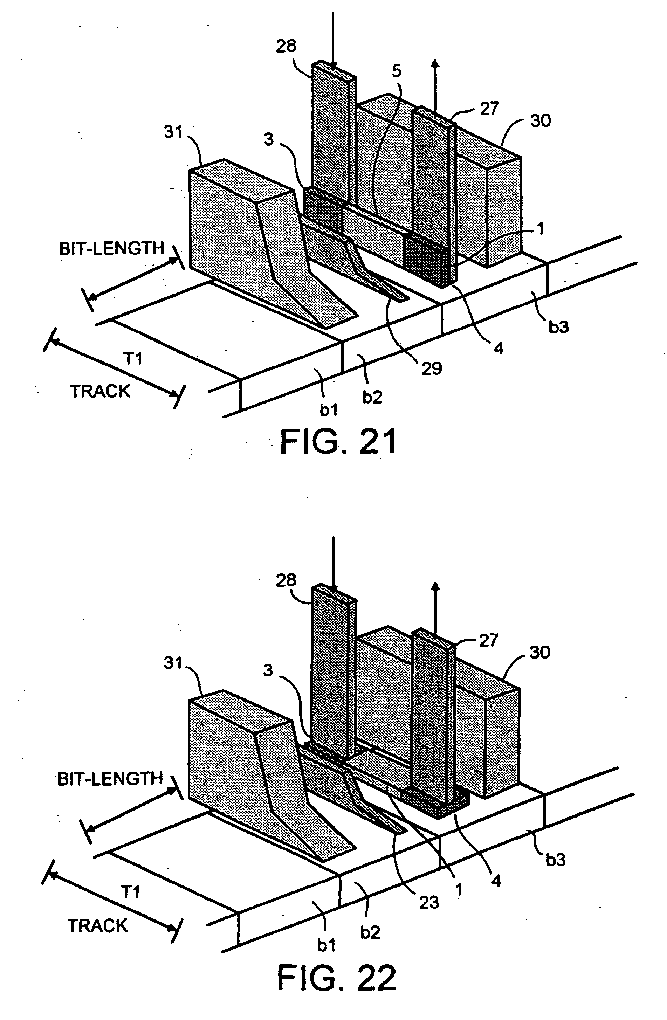

Figure 21 illustrates schematically an example of a magnetic reading head for use with magnetic storage medium such as a Winchester disc, incorporating a magnetoelectric device according to the invention. A substrate 1 incorporating the magnetoelectric device made according to any of the preceding examples is mounted between two current supply electrodes 27, 28 that are connected to the first and second ferromagnetic regions 3, 4, with channel tunnelling region 5 between them. The head is located over a magnetic storage medium such as the surface of a Winchester disc which contains tracks of magnetically recorded binary 1's and 0's. Three recorded bits b1, b2, b3, are shown schematically recorded in a track T1 in the magnetic recording medium. The bits may be recorded using a conventional induction coil (not shown) and a writing head 29 shown schematically. Magnetic shielding layers 30, 31 are provided on opposite sides of the head.

As the head is swept along the track, the applied field produced by the recorded bits changes between relatively high and low values depending on whether the underlying bit is 1 or 0. The changes in magnetic field produce corresponding changes in the current flowing between electrodes 27, 28, which can be detected by external circuitry (not shown) to detect the recorded information from the track T1.

A similar head is shown in Figure 22 and like parts are marked with the same reference numbers. In this example, the substrate 1 is disposed parallel with the surface of the track T1 and the electrodes 27, 28 extend orthogonally from it in contact with the ferromagnetic regions 3, 4.

The described examples of the invention have the advantage that the resistance of the reading head is reduced significantly as compared with conventional devices using an Al₂O₃ insulating film between the ferromagnetic layers. As a result, the device is less susceptible to external noise and provides an improved signal to noise ratio is in its output.

## Claims

1. A magnetoelectric device responsive to an applied magnetic field, comprising first and second ferromagnetic regions (3, 4) with a channel region (5) between them, the ferromagnetic regions (3, 4) being configured so that charge carriers with a particular spin polarisation which can pass through the first ferromagnetic region (3), pass through the second ferromagnetic region (4) as a function of the relative orientations of magnetisation of the ferromagnetic regions produced by the applied magnetic field whereby the device exhibits a conductivity as a function of the strength of the applied field, **characterised in that** the channel region (5) is configured to provide a quasi-one-dimensional channel to cause the charge carriers which pass through the first ferromagnetic region to maintain their spin polarisation as they pass towards the second ferromagnetic region.

2. A magnetoelectric device according to claim 1 wherein the channel region (5) comprises a nanotube (6).

3. A magnetoelectric device according to claim 2 wherein the channel region (5) comprises a bundle of nanotubes (6').

4. A magnetoelectric device according to claim 2 or 3 wherein the or each nanotube (6, 6') is made of carbon.

5. A magnetoelectric device according to claim 1 wherein the channel region (5) includes a layer of carbon containing material (14).

6. A magnetoelectric device according to claim 3 wherein the channel region (5) comprises a layer of graphite (14).

7. A magnetoelectric device according to claim 3 wherein the channel region comprises a diamond layer (14).

8. A magnetoelectric device according to claim 2 wherein the nanotube (6) is formed of boron nitride.

9. A magnetoelectric device according to claim 2 wherein the nanotube (6) is formed of silicon.

10. A magnetoelectric device according to any preceding claim wherein the first and second ferromagnetic regions (3, 4) comprise layers on a common substrate (1).

11. A magnetoelectric device according to claim 10 wherein the substrate (1) made of a metal, glass or silicon, and covered with an insulating layer (2) on which the ferromagnetic layers are formed.

12. A magnetoelectric device according to claim 11 wherein the insulating layer (2) comprises silicon oxide or nitride.

13. A magnetoelectric device according to any preceding claim wherein the first (3) and second (4) ferromagnetic regions are made of a cobalt containing material.

14. A magnetoelectric device according to any preceding claim including a gate (15, 15') to apply a field to the channel region.

15. A magnetic reading head for reading data from magnetic storage media, the head including a magnetoelectric device according to any preceding claim.

## Patentansprüche

1. Magnetoelektrische Vorrichtung, die auf ein angelegtes Magnetfeld reagiert, umfassend erste und zweite ferromagnetische Bereiche (3, 4) mit einem Kanalbereich (5) dazwischen, wobei die ferromagnetischen Bereiche (3, 4) dazu ausgelegt sind, dass Ladungsträger mit einer bestimmten Spinpolarisation, die durch den ersten ferromagnetischen Bereich (3) hindurchgelangen können, als Funktion der Relativorientierungen der durch das angelegte Magnetfeld erzeugten Magnetisierung der ferromagnetischen Bereiche durch den zweiten ferromagnetischen Bereich (4) hindurchgelangen, wodurch die Vorrichtung eine Leitfähigkeit als Funktion der Stärke des angelegten Felds aufweist, **dadurch gekennzeichnet, dass** der Kanalbereich (5) dazu ausgelegt ist, einen quasieindimensionalen Kanal bereitzustellen, um zu bewirken, dass die Ladungsträger, die durch den ersten ferromagnetischen Bereich hindurchgelangen, ihre Spinpolarisation beibehalten, wenn sie sich zum zweiten ferromagnetischen Bereich hin bewegen.

2. Magnetoelektrische Vorrichtung nach Anspruch 1, wobei der Kanalbereich (5) ein Nanoröhrchen (6) umfasst.

3. Magnetoelektrische Vorrichtung nach Anspruch 2, wobei der Kanalbereich (5) ein Bündel von Nanoröhrchen (6') umfasst.

4. Magnetoelektrische Vorrichtung nach Anspruch 2 oder 3, wobei das oder jedes Nanoröhrchen (6, 6') aus Kohlenstoff hergestellt ist.

5. Magnetoelektrische Vorrichtung nach Anspruch 1, wobei der Kanalbereich (5) eine Schicht aus kohlenstoffhaltigem Material (14) enthält.

6. Magnetoelektrische Vorrichtung nach Anspruch 3, wobei der Kanalbereich (5) eine Graphitschicht (14) umfasst.

7. Magnetoelektrische Vorrichtung nach Anspruch 3, wobei der Kanalbereich eine Diamantschicht (14) umfasst.

8. Magnetoelektrische Vorrichtung nach Anspruch 2, wobei das Nanoröhrchen (6) aus Bomitrid hergestellt ist.

9. Magnetoelektrische Vorrichtung nach Anspruch 2, wobei das Nanoröhrchen (6) aus Silizium hergestellt ist.

10. Magnetoelektrische Vorrichtung nach einem der vorhergehenden Ansprüche, wobei die ersten und zweiten ferromagnetischen Bereiche (3, 4) Schichten auf einem gemeinsamen Substrat (1) umfassen.

11. Magnetoelektrische Vorrichtung nach Anspruch 10, wobei das Substrat (1) aus Metall, Glas oder Silizium hergestellt und mit einer isolierenden Schicht (2) bedeckt ist, auf der die ferromagnetischen Schichten gebildet sind.

12. Magnetoelektrische Vorrichtung nach Anspruch 11, wobei die isolierende Schicht (2) Siliziumoxid oder -nitrid umfasst.

13. Magnetoelektrische Vorrichtung nach einem der vorhergehenden Ansprüche, wobei der erste (3) und der zweite (4) ferromagnetische Bereich aus einem kobalthaltigen Material hergestellt sind.

14. Magnetoelektrische Vorrichtung nach einem der vorhergehenden Ansprüche, umfassend ein Gate (15, 15') zum Anlegen eines Felds an den Kanalbereich.

15. Magnetischer Lesekopf zum Lesen von Daten von einem magnetischen Speichermedium, wobei der Kopf eine magnetoelektrische Vorrichtung nach einem der vorhergehenden Ansprüche enthält.

## Revendications

1. Dispositif magnétoélectrique réagissant à un champ magnétique appliqué, comprenant des première et seconde régions ferromagnétiques (3, 4), avec une région de canal (5) entre elles, les régions ferromagnétiques (3, 4) étant configurées de sorte que des porteurs de charges ayant une polarisation de spin particulière qui peuvent passer à travers la première région ferromagnétique (3), passent à travers la seconde région ferromagnétique (4) en fonction des orientations d'aimantation relatives des régions ferromagnétiques générées par le champ magnétique appliqué, grâce à quoi le dispositif présente une conductivité qui est fonction de l'intensité du champ appliqué, **caractérisé en ce que** la région de canal (5) est configurée pour procurer un canal pratiquement unidimensionnel pour amener les porteurs de charges, qui passent à travers la première région ferromagnétique, à conserver leur polarisation de spin lorsqu'ils abordent la seconde région ferromagnétique.

2. Dispositif magnétoélectrique selon la revendication 1, dans lequel la région de canal (5) comprend un nanotube (6).

3. Dispositif magnétoélectrique selon la revendication 2, dans lequel la région de canal (5) comprend un faisceau de nanotubes (6').

4. Dispositif magnétoélectrique selon la revendication 2 ou 3, dans lequel le ou chaque nanotube (6, 6') est fait de carbone.

5. Dispositif magnétoélectrique selon la revendication 1, dans lequel la région de canal (5) comprend une couche d'un matériau (14) contenant du carbone.

6. Dispositif magnétoélectrique selon la revendication 3, dans lequel la région de canal (5) comprend une couche de graphite (14).

7. Dispositif magnétoélectrique selon la revendication 3, dans lequel la région de canal comprend une couche de diamant (14).

8. Dispositif magnétoélectrique selon la revendication 2, dans lequel le nanotube (6) est formé de nitrure de bore.

9. Dispositif magnétoélectrique selon la revendication 2, dans lequel le nanotube (6) est formé de silicium.

10. Dispositif magnétoélectrique selon l'une quelconque des revendications précédentes, dans lequel les première et seconde régions ferromagnétiques (3, 4) comprennent des couches d'un substrat commun (1).

11. Dispositif magnétoélectrique selon la revendication 10, dans lequel le substrat (1) est fait d'un métal, de verre ou de silicium et recouvert d'une couche d'isolement (2) sur laquelle les couches ferromagnétiques sont formées.

12. Dispositif magnétoélectrique selon la revendication 11, dans lequel la couche d'isolement (2) comprend de l'oxyde ou du nitrure de silicium.

13. Dispositif magnétoélectrique selon l'une quelconque des revendications précédentes, dans lequel les première (3) et seconde (4) régions ferromagnétiques sont faites d'un matériau contenant du cobalt.

14. Dispositif magnétoélectrique selon l'une quelconque des revendications précédentes, comprenant une grille (15, 15') afin d'appliquer un champ à la région de canal.

15. Tête de lecture magnétique destinée à lire des données à partir d'un support de mémorisation magnétique, la tête comprenant un dispositif magnétoélectrique selon l'une quelconque des revendications précédentes.
